**Europäisches Patentamt**

**European Patent Office**

**Office européen des brevets**

(11) Veröffentlichungsnummer: **0 308 611**
**A1**

(12) # EUROPÄISCHE PATENTANMELDUNG

(21) Anmeldenummer: **88111642.0**

(51) Int. Cl.4: **H02N 11/00**

(22) Anmeldetag: **20.07.88**

(30) Priorität: 25.09.87 DE 3732312
05.01.88 DE 3800098
06.05.88 DE 3815500

(43) Veröffentlichungstag der Anmeldung:
**29.03.89 Patentblatt 89/13**

(84) Benannte Vertragsstaaten:
**AT BE CH DE ES FR GB GR IT LI LU NL SE**

(71) Anmelder: **Stephan, Hans-Wilhelm**
**Reiche Gasse 8**
**D-8886 Wittislingen(DE)**

Anmelder: **Munk, Heinz**
**Ulrichstrasse 18**
**D-8881 Haunsheim(DE)**

(72) Erfinder: **Stephan, Hans-Wilhelm**
**Reiche Gasse 8**
**D-8886 Wittislingen(DE)**
Erfinder: **Munk, Heinz**
**Ulrichstrasse 18**
**D-8881 Haunsheim(DE)**

(54) **"Magnetokalorische monostabile- und bistabile- Induktoren," zur Erzeugung elektrischer Energie- und zur Kälte-Erzeugung.**

(57) Gegenstand der Erfindung sind Magnetkreise mit integrierten metamagnetischen Plättchen, Permanentmagneten, Dynamoblechkernen und Spulen, die sich in ihrer Funktionsweise ähnlich den elektronischen Analogiesystemen Monoflop und Flip-Flop verhalten.

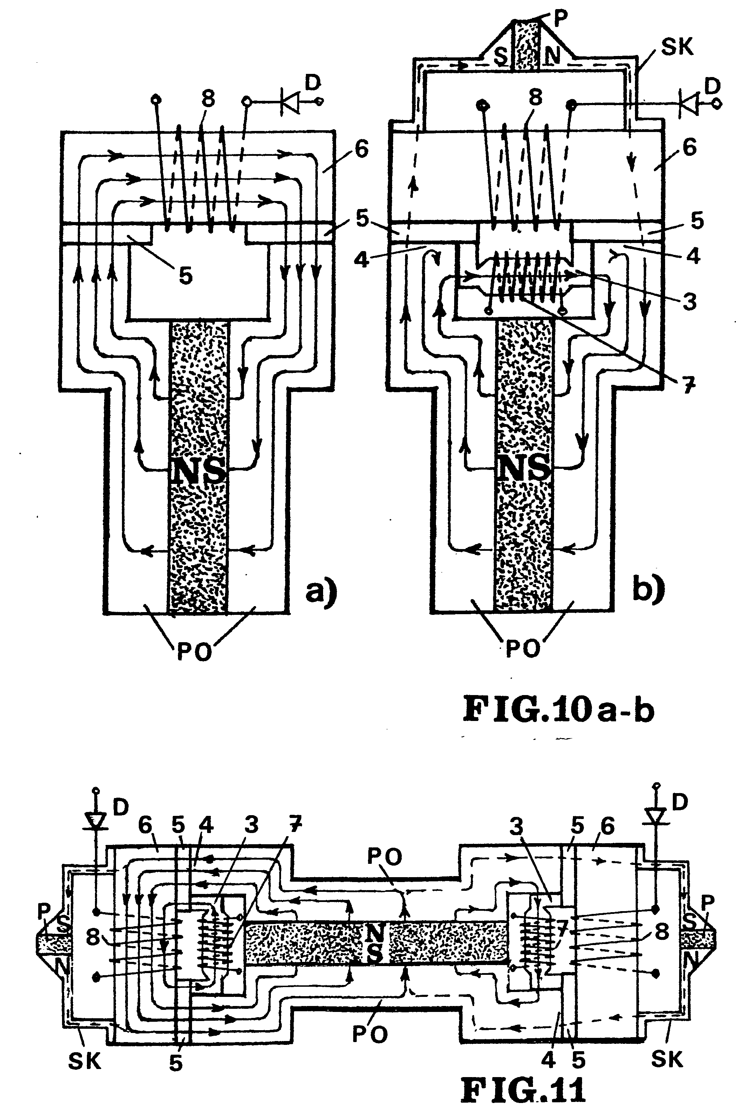

In der Figur 10 b ist ein magnetisches Monoflop dargestellt. Seine magnetischen physikalischen Schaltelemente sind monokristalline metamagnetische Plättchen 5, welche zwischen den Dynamoblech-Polschuhen PO des Permanentmagneten N-S und dem Jochblechkern 6 mit Induktionsspule 8 angeordnet sind. Jeder Steuerstrom-Impuls durch Spule 7 löst elektromagnetisch einen Magnetisierungssprung in den metamagnetischen Plättchen 5 aus, wegen Überschreitung ihrer kritischen Schwellfeldstärke, dabei schalten sie vom statisch bevorzugten antiferro- in den ferro- magnetischen Zustand um und nach Ausklingen des Steuerimpulses- zurück, wobei der Jochkern 6 auf- und wieder ent- magnetisiert wird! Die elektrische Leistungsabgabe der Induktionsspule 8 übersteigt während der Entmagnetisierung ihres viel grösseren Jochkernes 6, die Steuerimpuls- Leistung für den viel kleineren Steuerkern 3 erheblich,

deshalb tritt ein magnetokalorisches, die Plättchen 5 abkühlendes Energiedefizit auf, das thermisch ausgeglichen werden muß! Die Diode D verhindert ein Induktionsspule 8 Gegenfeld während der Aufmagnetisierung des Jochkernes 6 und der Kern SK kompensiert den Antiferromagnetischen Feldübertritt.

**FIG.10 a-b**

## Magnetokalorische monostabile- und bistabile Induktoren zur Erzeugung elektrischer Energie- und zur Kälte -Erzeugung.

Der magnetokalorische Effekt, oder seine Umkehr, wurde bisher nur zur Erreichung sehr tiefer Temperaturen nahe des absoluten Nullpunktes genützt.

Die magnetokalorische Energiewandlung eröffnet phantastische Möglichkeiten wen man bedenkt, daß sie den allgegenwärtigen Brennstoff, nämlich die Umweltwärme von Luft, Wasser und Boden bis hinab zu Wärmevorkommen von Polarregionen, also bis minus 100° C noch zu elektrischer Energie verwerten, oder umwandeln kann - und dies rund um die Uhr "dauerverfügbar" !

Allerdings ist eine derartige Niedertemperatur-Umwandlung nur mit Hilfe von Stoffen, welche außergewöhnliche magnetische und kalorische Eigenschaften aufweisen, in besonderen Magnetkreisen möglich!

Bei der vorliegenden Erfindung wird die physikalische Eigenschaft, insbesondere einkristalliner metamagnetischer Stoffe ausgenützt, plötzlich sprunghaft beim Überschreiten ihrer kritischen Schwellfeldstärke ferromagnetisch leitend zu werden - und beim geringfügigen Unterschreiten dieser kritischen Feldstärke - Schwelle, ebenso plötzlich in ihren antiferromagnetischen Zustand zurück zu springen, sie sind deshalb "ideale magnetische Schalter" !

Begleitet und verbunden sind diese magnetischen Zustandsänderungen, oder Phasenübergänge der metamagnetischen Stoffe von ausgeprägtem magnetokalorischem Effekt. Literaturquellen:

Zeitschrift für angewandte Physik, April 1962, Heft 4 Prof. Eckhart Vogt, Phys.-Institut Universität Marburg "Metamagnetismus".

Fiz. Tverd. Tela (Leningrad) 21, 2808-2810 (Sept.1979) S.A. Nikitin, A.S. Andreenko and V.A. Pronin. "Magnetocaloric effect and magnetic phase transitions in a dysprosium single crystal".

Der Erfindung lag die Idee zugrunde, einen effektiven physikalischen magnetischen Schalter, für eine Magnetkreisanordnung zu finden, welcher - so wie ein Thyristor oder Transistor als Schalter in einem Gleichstromkreis, einen sehr großen Unterschied zwischen steuernd schaltender und weit größerer geschalteter elektrischer Energie aufweist, - in magnetisch analoger Weise, durch sehr viel kleinere elektromagnetische Steuerenergie, eine weit größere magnetische Energie zu schalten vermag, die dann induktiv in Form elektrischer Energie aus dem Magnetkreis ausgekoppelt werden kann und das dadurch in dem im Magnetkreis angeordneten Metamagnetikum entstehende, magnetokalorische Energiedefizit, durch Zufuhr von Niedertemperatur-Wärme, auszugleichen.

Es wurde bisher kein brauchbarer Weg gefunden, Niedertemperatur - Wärme direkt oder indirekt in höherwertige elektrische Energie umzuwandeln, denn nur die "mechanische Umwandlung" ist nach dem 2. Hauptsatz der Wärmelehre nicht möglich !

Mit vorliegender Erfindung zeichnet sich eine gangbare Möglichkeit ab, die Niedertemperatur-Umwandlung zu realisieren, weil sehr geringe elektromagnetische Steuerfelder und Flüße, für die physikalisch - magnetischen Schaltvorgänge im Umwandlungsbereich der kritischen Schwellfeldstärke von Metamagnetikas ausreichen, - um mehrfach größere magnetische Felder und Flüße eines Magnetkreises ein- und aus- zu schalten, wodurch in den Induktionsspulen der metamagnetisch abgeschalteten Magnetkreiskernteile,im Vergleich zur Steuerleistung, eine mehrfach höhere elektrische Leistung induziert wird, die sich magnetokalorisch abkühlend auf das Metamagnetikum auswirkt !

Die Figuren 1a und 1b zeigen schematisch erfindungsgemäße bistabile - Induktoren, "magnetische Flip-Flops", mit Feldlinienverlauf und antiferromagnetischer Streufluß -Kompensation.

Die Figuren 2a und 2b zeigen schematisch erfindungsgemäße bistabile - Induktoren, mit Feld- und Flußverdichtungs -Kernteilen, Feldlinienverlauf und antiferromagnetischer Streufluß-Kompensation.

In der Figur 3 wird die Magnetisierungskurve der metamagnetischen polykristallinen Mangan - Goldlegierung Mn-Au$_2$ gezeigt, während die Figur 4 die Magnetisierungskurven von einkristallinem Dysprosium, einem Selten - Erdmetall, darstellt.

Die Figur 5 zeigt perspektivisch ein technisches Ausführungsbeispiel der Erfindung nach Figur 1 a und die Figur 6 ein Verbindungsteil für die Figur 5.

Die Figur 7 a-b-c zeigt in starker Vergrößerung erfindungsgemäße metamagnetische Plättchen-Ausführungen. Die Figur 8 zeigt ein einzelnes Jochkern - Dynamoblech. In Figur 9 wird der Kreislauf flüssiger oder gasförmiger Medien, durch die metamagnetischen, in die Magnetkreise eingefügten Plättchenlamellen, einer größeren Anzahl magnetokalorischer bistabiler Induktoren, in Verbindung mit Wärmetauscher und Kreislaufpumpe gezeigt. Die Figur 10 a-b zeigt erfindungsgemäße monostabile Induktoren in Eintakt- und Figur 11 in Gegentakt-Ausführung.

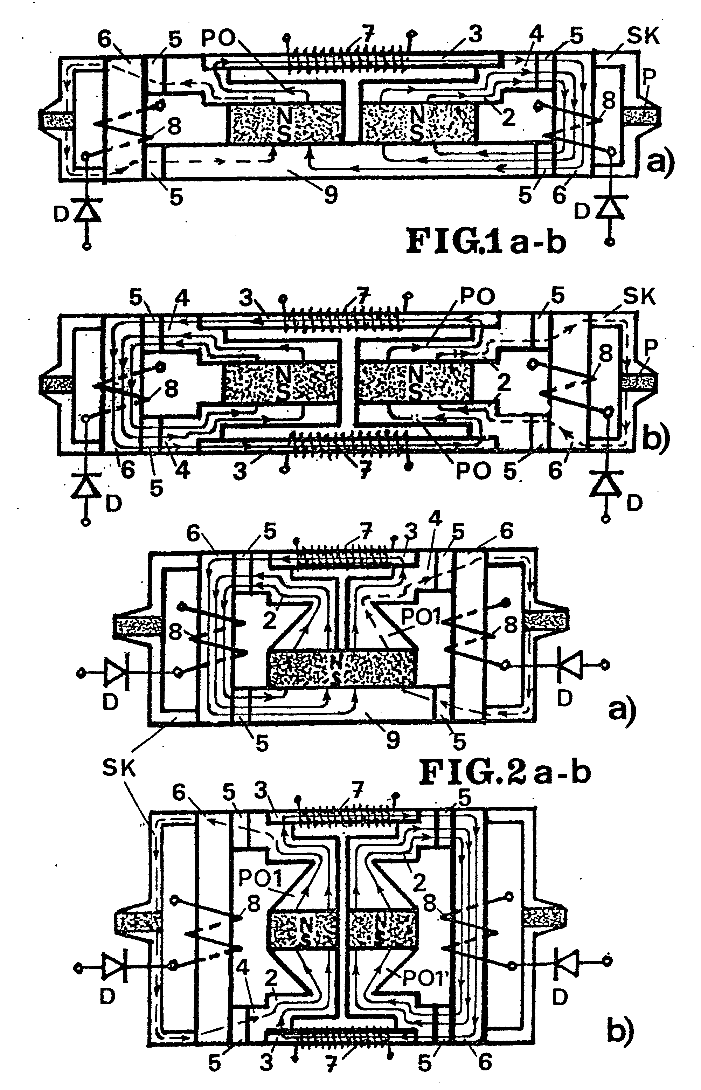

Die Figuren 1a und 1b zeigen schematisch je zwei spiegelbildlich gleiche Magnetkreise, mit Permanentmagneten N-S, Polschuhen Po aus Dynamoblech, metamagnetischen Plättchen 5, 5′, Dynamoblech - Jochkerne 6, 6′ mit Induktionsspulen 8, 8′ und Streufluß- Kompensationskernen SK mit kleinen Permanentmagneten P.

Die beiden Magnetkreise sind in Figur 1a nur durch einen Steuerkern 3 mit Steuerspule 7, mit je einem magnetisch gleichnamigen Magnetpolschuh Po einerseits und auf der anderen Polseite, durch einen Rückschlußkern 9 miteinander verbunden.

In Figure 1b dagegen sind die beiden Magnetkreise nur durch zwei Steuerkerne 3, mit jeweils magnetisch gleichnamigen Polschuhen Po miteinander verbunden, natürlich mit je einer Steuerspule 7, gewickelt auf die Kerne 3. Der Kernquerschnitt im Abschnitt 4 dr Polschuhe Po, entspricht der Addition des Polschuhquerschnitts in seinem Abschnitt 2, mit dem Steuerkernquerschnitt 3, dadurch wird erreicht, daß ohne zusätzlichen magnetischen Fluß durch den Steuerkern 3, die Feldstärke jedes Permanentmagneten N-S in seinem eigenen Kernabschnitt 4 seines Magnetkreises, zur Überwindung der metamagnetischen kritischen Schwell- oder Schaltfeldstärke- Barriere seiner Plättchenstapel 5, 5', gerade noch nicht ausreicht.

Wird nun ein Stromstoß in Figur 1a durch die Steuerspule 7 geleitet und damit der Steuerkern 3 zum Elektromagneten, so wird die Feldstärke je nach Stromrichtung, in einem der beiden Polschuhabschnitte 4 über die kritische Schwell- oder Schaltfeldstärke der angrenzenden Plättchenstapel 5, 5' hinaus erhöht, die Plättchen 5 oder 5' dadurch ferromagnetisch leitend und der zugehörige Jochkern 6 oder 6' aufmagnetisiert.

Durch die Diode D wird sichergestellt, daß während dieser Aufmagnetisierung eines Jochkernes 6 oder 6', kein den metamagnetischen Schaltvorgang verhindernder Induktionsstrom in Spule 8 oder 8' fließen kann, welcher nach der Lenz'schen Regel sonst ein gleichnamiges Gegenfeld dem Aufmagnetisierungsfeld entgegensetzen würde. Die Aufgabe der Diode D kann auch ein Thyristor übernehmen, welcher mit den Rückflanken der Steuerimpulse gezündet wurden kann.

Ein Stromstoß mit entgegengesetzter Stromrichtung in Steuerspule 7 bewirkt nun, daß die Schwell- oder Schaltfeldstärke der eben noch ferromagnetisch leitenden metamagnetischen Plättchen 5 oder 5' unterschritten und gleichzeitig bei den gegenüberliegenden Plättchen 5' oder 5 des anderen Mangetkreises, überschritten wird. Somit wird der andere Jochkern 6' oder 6 aufmagnetisiert, der metamagnetisch abgeschaltete Jochkern 6 oder 6' aber entmagnetisiert.

Jeder dem vorhergehenden in seiner Richtung entgegengesetzte Stromimpuls in der, oder den Spulen 7 der Figuren 1a und 1b, kippt also die beiden Jochkerne 6 und 6' der Magnetkreise, in entgegengesetzte magnetische Zustände um. Es sind also bistabile magnetische Systeme,- in der elektronischen Analogie - "Flip- Flops" !

Da für die kurzen Schaltstrom - Impulse durch Steuerspulen 7, mit im Kernquerschnitt gegenüber den Jochkernen 6 6' wesentlich kleineren Steuerkernen 3, viel weniger elektrische Leistung benötigt wird,-als über die Dioden D, oder gezündete Thyristoren, aus den Induktionsspulen 8, 8' während den Entmagnetisierungsphasen der Jochkerne 6, 6' ausgekoppelt werden kann, entsteht in den metamagnetischen Plättchen 5, 5', welche die Unterbrechung des starken magnetischen Flußes bewirken, ein magnetokalorischer Energiemangel, welcher der aus den Jochkernen 6, 6' entzogenen elektrischen Induktionsenergiemenge entspricht.

Die metamagnetischen Plättchen 5, 5' erfahren eine dementsprechende Abkühlung, welcher, um ein Abtriften der kritischen Feldstärke- Schwelle zu niedereren Werten hin zu verhindern, durch äquivalente Wärmezufuhr entgegengewirkt werden muß !

Die im antiferromagnetischen Schaltzustand der Plättchen 5, 5' auftretenden, schädlichen magnetischen Streuflüße, werden durch die Streufluß- Kompensationskerne SK kompensiert, um eine Vormagnetisierung und mangelhafte Entmagnetisierung der Jochkerne 6, 6', zu verhindern.

Die Streufluß- Kompensationskerne SK sind im Querschnitt so ausgelegt, daß sie bereits mit dem Streufluß magnetisch gesättigt sind, damit der Magnetisierungssprung bei der Aufmagnetisierung, voll den Jochkernen 6, 6' zu gute kommt. Die Streufluß- Kompensationskerne SK können auch aus massivem Weicheisen, wegen ihres konstanten magnetischen Flußes, bestehen.

Die Figur 2a und 2b entspricht in der Funktionsweise genau den Figuren 1a und 1b, nur mit dem Unterschied, daß bei Verwendung von Permanentmagneten N-S geringer Flußdichte, die Dynamoblech- Polschuhe Po 1 und Po 1' sich von den Magnetpolflächen aus, zu den Kernabschnitten 2 hin, feldverdichtend verjüngen !

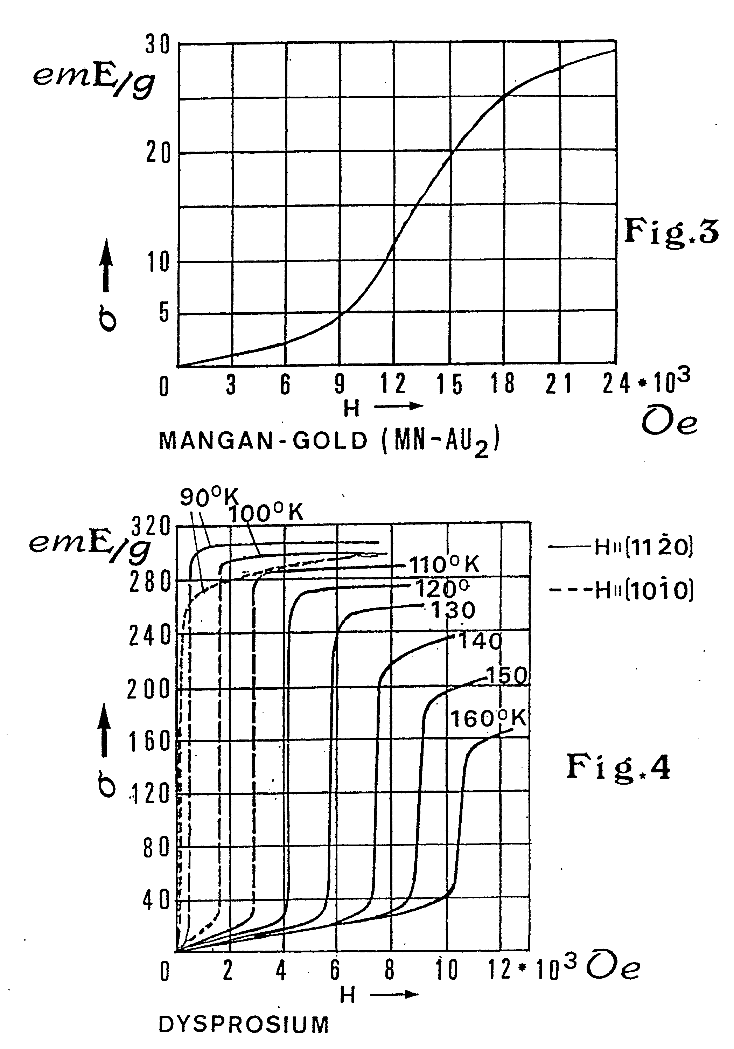

Die Figur 3 zeigt die Magnetisierungskurve bei Temperaturen zwischen 20°C - 40°C, der polykristallinen metamagnetischen Mangan - Gold Legierung $Mn-Au_2$, welche wegen ihrer regellosen Kristallit - Orientierung einen zu flachen Magnetisierungs- Anstieg nach Überschreitung der kritischen Schwellfeldstärke aufweist.

Man müßte deshalb für die erfindungsgemäße Anwendung Einkristalle dieser Legierung herstellen und wenn dies nicht möglich sein sollte, könnte eine Zerkleinerung der natürlichen polykristallinen Legierung und Ausrichtung der entstehenden kleinen Einkriställchen im Magnetfeld, mit anschließendem Pressen und Sintern, Abhilfe schaffen !

Die Figur 4 zeigt die Magnetisierungskurven bei verschiedenen Umwandlungs- Temperaturen und zugehörigen kritischen Schwellfeldstärken, des metamagnetischen Selten -Erdmetalles Dysprosium. Diese idealen Magnetisierungskurven von nahezu senkrechter Steilheit, wurden an einem gezüchteten Dysprosium - Einkristall gemessen.

Obwohl nur bei relativ tiefen Temperaturen metamagnetisch dürfte dieses gar nicht so rare Metall wegen seiner hohen Magnetisierungswerte im ferromagnetischen Zustand und noch günstigen Preises, für die Plättchen 5, 5' der Erfindung, das bevorzugte Material sein.

Die tiefe Funktionstemperatur des Dysprosiums ist auch deshalb kein Nachteil, weil die Induktoren selbst Hochleistungs - Kühlaggregate sind, solange ihnen elektrische Leistung abverlangt wird, sie halten von sich aus ihre tiefe Arbeitstemperatur aufrecht, es muß im Gegenteil über Wärmetauscher ihrem Kreislaufmedium eine ausreichende Wärmemenge zugeführt werden.

Nur zum "Starten muß ihr flüssiger oder gasförmiger Medienkreislauf, einmal auf die Funktionstemperatur des Dysprosiums fremdgekühlt werden !

Es kann also mit den erfindungsgemäßen magnetokalorischen Induktoren, gleichzeitig elektrische Energie und Kälte erzeugt werden.

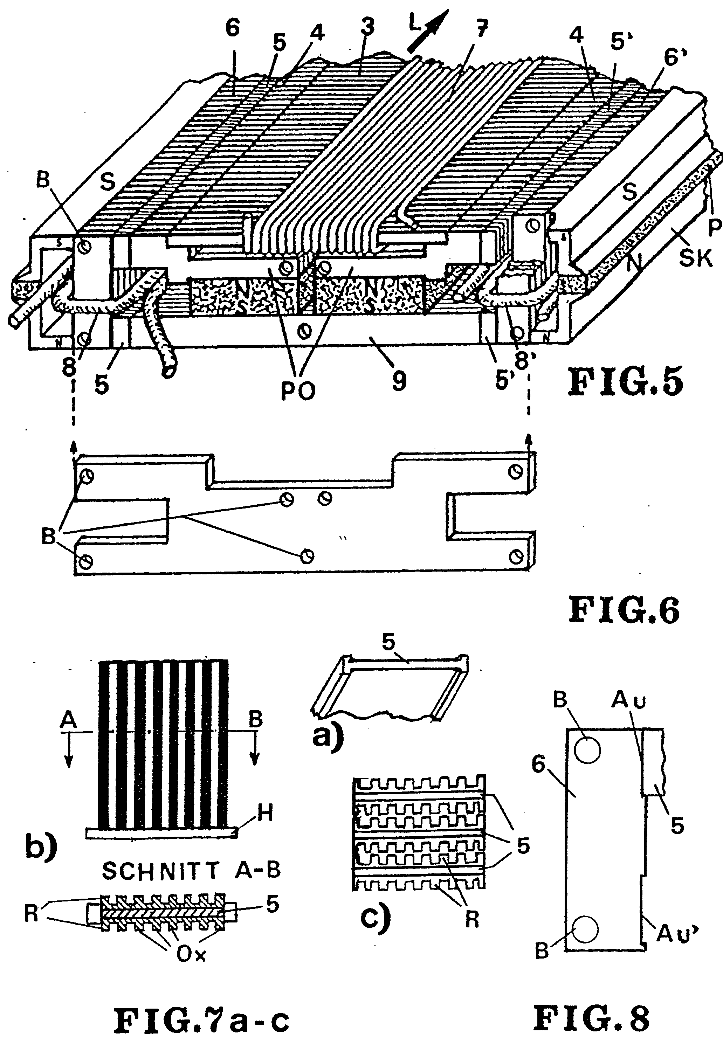

Die Figur 5 zeigt ein technisches Ausführungsspiel der Erfindung nach Figur 1a in perspektivischer Ansicht, hierbei sind sowohl in den Jochkernen 6, 6', wie auch in den Polschuhen Po und Rückschlußkernen 9, Befestigungsbohrungen B vorgesehen.

In Pfeilrichtung L können die Magnetkreise relativ lang ausgeführt werden.

Die Figur 6 zeigt ein Verbindungsteil perspektivisch für die Figur 5, aus Pertinax , Aluminium oder anderen nicht magnetisierbaren Stoffen, ebenfalls mit Bohrungen B, deckungsgleich mit den Bohrungen B der Figur 5, um die Magnetkreisteile mit Gewindestangen wie auch bei Transformatoren üblich unverrückbar miteinander verbinden zu können. Bei langen stangenförmigen Ausführungen der Figur 5, müssen wiederholt solche Verbindungsteile zur Erhaltung der mechanischen Stabilität und der genauen Abstände der Magnetkreis- Einzelteile, zwischendurch eingefügt werden.

Da die Magnetkreise an ihren den Plättchen 5, 5' zugewanden Polschuh- und Rückschlußkern- Enden, selbst bei Verwendung von stärksten Samarium-Kobalt-Magneten, keine beliebig hohe Feldstärke erzeugen können und die an den Plättchen 5, 5' zustande kommende Feldstärke, von der Breite dieser Plättchen 5, 5', die den Abstand zu Jochkernen 6, 6' bildet, abhängig ist, - muß aus diesen Gründen die Plättchenbreite im Bereich des noch von den Magnetkreisen-, mit Hilfe des Steuerkernflußes überschreitbaren,Schwell- oder Schaltfeldstärke- Wertes bleiben.

Diese Breite der Plättchen 5, 5' ist also aus physikalischen Gründen, egal wie groß die Magnetkreise ausgeführt werden, ein unveränderbares Maß, bei gleichem metamagnetischem Grundstoff! Aus diesem Grunde ist es nachteilig, besonders große Magnetkreise herzustellen, weil in diesem Fall sämtliche Magnetkreisteile zweidimensional zunehmen, während die Plättchen 5, 5' aber wegen der unveränderbaren Breite, nur eindimensional vergrößert werden können.

Umgekehrt ist es sinnvoller, die Magnetkreise zu verkleinern, weil die Plättchen 5, 5 - Breite gleichbleibt und nur ihre Höhe abnimmt, die anderen Teile mit Ausnahme der Ausdehnung in Pfeilrichtung L der Figur 5, aber in ihrer Flächenausdehnung im Quadrat abnehmen. Das Größenverhältnis flächenmäßig betrachtet, insbesondere von Jochkern- zu Plättchen- Flächen, verändert sich somit bei Verkleinerung der Magnetkreisteile,- zu Gunsten der Plättchen 5, 5'- Flächen !

Das ist eine "wichtige Tatsache, den was nützt ein großer Jochkern 6, 6', wenn die im Verhältnis zu ihm zu kleinen Plättchen 5, 5' und damit auch zu kleiner Plättchenoberflächen, mit ihrer Wärmeaufnahmefähigkeit, nicht mit der möglichen großen elektrischen Energieauskopplung der zu großen Jochkerne 6, 6 ! , Schritt halten können ! Bei einer gleitend-fortgesetzten zweidimensionalen und aber bei Plättchen 5, 5' nur "eindimensionaler Verkleinerung der stirnseitigen Flächenmaße der Magnetkreise, wird also sehr bald die Größenordnung erreicht, bei der die mögliche elektrische Leistungsabgabe, mit der Wärmemengen- Aufnahmefähigkeit der Plättchen 5, 5'- Oberflächen, im energetischen Gleichgewicht ist.

Dieses energetische Gleichgewicht wird natürlich umso früher erreicht, je mehr sich die Plättchenoberflächen, bei gleichbleibender Breite der Plättchen 5, 5', künstlich vergrößern lassen.

Die Figur 7 a-b-c zeigt in vergrößertem Maßstab, solche erfindungsgemäße Oberflächenvergrößerungs-Möglichkeiten der metamagnetischen Plättchen 5, 5', auf.

Während die Figur 7a perspektivisch und in der Höhe gekürzt, ein normales Plättchen 5 mit der kleinsten Oberfläche darstellt, welches mit anderen gleichgestalteten Plättchen 5 aneinandergereiht, schmale Schlitze zum Mediendurchtritt freiläßt, ist in Figur 7b ein Plättchen 5 in der Flächendraufsicht und im Schnitt A-B zu sehen, auf dessen Oberfläche streifenförmig durch Aufdampfen, galvanisch, oder mit anderen geeigneten Verfahren, beidseitig, gut wärmeleitende schmale Kupfer-, oder Silber-Rippen R, zur Vergrößerung der Oberflächen aufgetragen sind, oder in ein dickeres metamagnetisches Plättchen 5, solche Rippen R durch streifenförmiges Ätzen, oder mit anderen geeigneten Materialabtragungs- Verfahren hergestellt werden. Zur Isolierung können die stirnseitigen Oberflächen der Rippen R mit einer Oxyd Ox, oder Lackschicht versehen sein. Die Plättchen 5 können außerdem aufgelötete Haltestäbchen H , welche über die Plättchen-Breite hinausragen,oder auch keine solche, aufweisen. In Figur 7c sind stirnseitig betrachtet, aneinander gereihte Plättchen 5, mit der größten Oberfläche dargestellt, sie entsprechen der Figur 7b, ihre Rippen R sind jedoch mit Ausnahme der seitlichen äußeren Rippen, auf den beiden Flächenseiten so gegeneinander verschoben, daß aneinander gereiht, jede Rippenstirnseite einer Vertiefung gegenüberliegt.

Die Figur 8 zeigt ein einzelnes erfindungsgemäßes Jochkernblech 6, mit geringen Ausnehmungen Au, welche dazu dienen,die Plättchen 5, 5' festzuhalten. Gleiche geringe Ausnehmungen gegen ein Abgleiten der Plättchen 5, 5' in das Innere des Magnetkreises, können auch die Polschuh Po Stirnseiten im Kernabschnitt 4 , aufweisen.

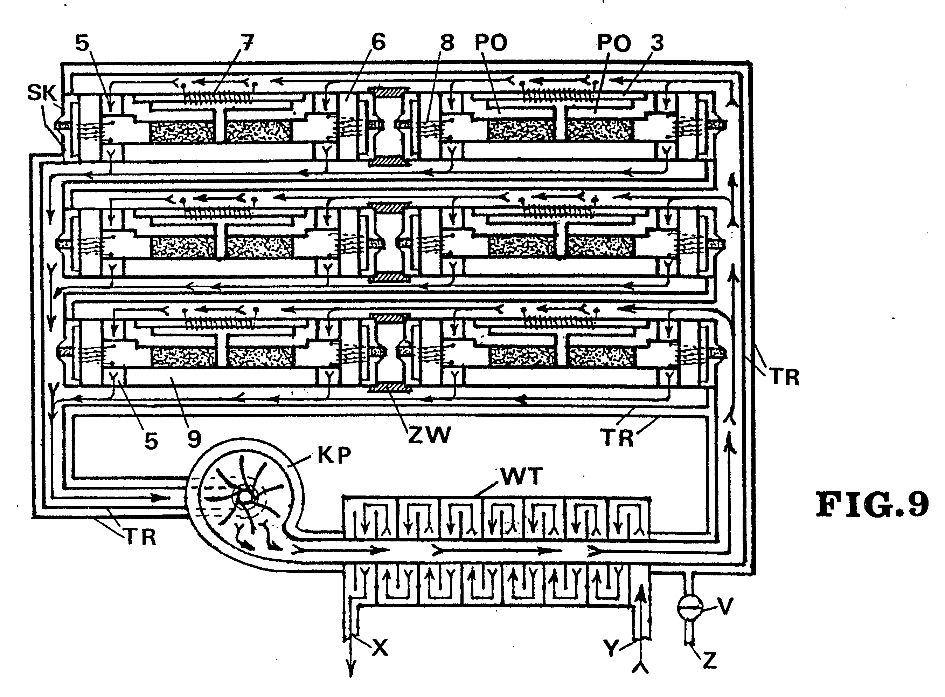

In der Figur 9 wird eine Anordnung von sechs magnetokalorischen Gegentakt-Induktoren nach Figur 1a und Figur 5 gezeigt, welche zu einer nahezu kompletten Anlage zur elektrischen Energie- und Kälte- Erzeugung zusammengefaßt sind.

Eine Kreislaufpumpe KP befördert hierbei das flüssige Kältemittel durch einen Wärmetauscher WT und in den Pfeilrichtungen durch die Schlitze der Plättchen 5, 5' in einem Kreislauf zurück zur Kreislaufpumpe KP. Um einen unerwünschten Wärmedurchtritt durch das Stahlblechgehäuse, in welchem die Induktoren untergebracht sind, zu verhindern, wird das Stahlblechgehäuse aus doppelwandigen Trennwänden TR gebildet und im Zwischenraum evakuiert. Eine Vakuumpumpe wird an den Anschluß Z angeschlossen.

Um die elektrische Energie- und Kälte- Erzeugung anzuwerfen, muß nur zum Start, um das Dysprosium der Plättchen 5, 5' auf seine Funktionstemperatur von etwa 150°K zu bringen, an die Anschlüße X und Y eine externe Kältemaschine angeschlossen werden!

Danach genügt es, fortgesetzt elektrische Energie aus den Induktoren auszukoppeln, um nicht nur die tiefe Temperatur der Anlage aufrecht zu erhalten, sondern sogar noch thermische Energie dem Wärmetauscher WT entziehen zu können !

Darüber hinaus könnte auch bei größerem Wärmeverbrauch das Vakuum zwischen den Trennwänden TR, durch das Ventil V, veringert werden.

Wie in Figur 9 weiter erkennbar ist, hat sich durch die zweidimensionale und bei den Plättchen 5 nur eindimensionaler zeichnerischer Verkleinerung der Magnetkreise, gegenüber den Figuren 1a und 5, das Oberflächenverhältnis zu Gunsten der Plättchen 5 verändert !

Die Figuren 10 a - b zeigen ein weiteres Ausführungsbeispiel der Erfindung, einen monostabilen magnetokalorischen Induktor.

Der Magnetkreis in Figur 10 a, bestehend aus Permanentmagnet N-S, Dynamoblech- Polschuhen PO, metamagnetischen Plättchen 5, Jochkern 6 mit Induktions- Spule 8, wird so dimensioniert, daß die auf die Plättchen 5 einwirkende Feldstärke, über ihrem Schwellfeldstärkewert liegt. Die metamagnetischen Plättchen 5 werden dadurch in den ferromagnetisch leitenden Zustand durchgeschaltet.

Wird nun in denselben Magnetkreis - wie in Figur 10 b dargestellt, ein kleiner Dynamoblech- Steuerkern 3 mit Spule 7 eingefügt, so wird ein Teil des magnetischen Flußes über diesen Steuerkern 3 kurzgeschlossen, wodurch die Felddichte im Polschuhabschnitt 4 unter den Schwellfeldstärkewert der metamagnetischen Plättchen 5 absinkt und ihren Magnetisierungsrücksprung in den antiferromagnetischen Zustand bewirkt.

Wird nun durch die Steuerspule 7 des Steuerkernes 3 ein Stromstoß geleitet, welcher ein Feld erzeugt das dem kleinen magnetischen Abzweigungsfluß entgegenwirkt und seine Flußrichtung umkehrt, dann steigt die Feldstärke im Polschuhabschnitt 4 wieder auf den ursprünglichen hohen Wert wie bei Figur 10a über die Schwellfeldstärke der Plättchen 5 an, schaltet sie in ihren ferromagnetischen Zustand um und magnetisiert den Jochkern 6 auf.

Auch hier kann die Induktions- Spule 8 während der Aufmagnetisierung des Kernes 6 kein Gegenfeld aufbauen,weil die Diode D diese Stromrichtung sperrt!

Nach Unterbrechung oder Richtungsumkehr des Steuerstromes der Spule 7, wird ein magnetischer Teilfluß wieder über den Steuerkern 3 kurzgeschlossen und die Plättchen 5 schalten in ihren statisch bevorzugten antiferromagnetischen Zustand zurück.

Die Induktions- Spule 8 versucht natürlich entsprechend der Lenz'schen Regel, nach der Aufmagnetisierung ihres Kernes 6, nun den Zustand der magnetischen Sättigung aufrecht zu erhalten, wenn ihr Jochkern 6 sich in Folge des Abschaltvorganges entmagnetisieren will, die Spule 8 kann den Magnetisierungs- Rücksprung der Plättchen 5 in ihren monostabilen bevorzugten antiferromagnetischen Zustand aber nur verzögern, weil ihr Haltefeld,erzeugt durch den Induktionsstrom, letztlich nur durch die sich fortsetzende Feldänderung in Richtung weiterer Entmagnetisierung ihres Kernes 6,- gespeist wird.

Es ist ähnlich wie bei seiner Dynamomaschine, je mehr Strom verbraucht wird, desto stärker wird sie gebremst ! Dieser durch den Stromverbrauch eines angeschlossenen Verbrauchers gebremste Magnetisierungs- Rücksprung des Metamagnetikums, verzehrt thermische Energie und muß um ein Abtriften des Schwellfeldstärkewertes in Folge der Abkühlung zu verhindern, durch das Kreislaufmedium ausgeglichen werden!

Die Figur 11 zeigt eine Anordnung zweier monostabiler magnetokalorischer Induktoren nach Figur 10 b in Gegentakt- Schaltung.

Die Polschuhe PO dieser monostabilen Induktoren können natürlich auch mit Feldverdichtungs- Kernteilen PO 1 nach den Figuren 2 a-b versehen werden, die sich von den Magnetpolflächen ausgehend - zum Kernabschnitt 4, oder biz zum einmündenden Steuerkern 3 hin, im Querschnitt verjüngen.

## Ansprüche

1.) "Magnetokalorische monostabile- und bistabile Induktoren zur Erzeugung elektrischer Energie- und zur Kälteerzeugung, dadurch gekennzeichnet, daß sie aus ein bis zwei Magnetkreisen mit Permanentmagneten (N-S), Dynamoblech-Polschuhen (PO,PO 1), einkristallinen metamagnetischen Plättchen (5, 5$'$) und Jochkernen (6, 6$'$) mit Induktions-Spulen (8, 8$'$), ein- bis zwei Steuerkerne (3) mit Steuer- Spulen (7), sowie Strefluß- Kompensationskernen (SK) mit Kompensations- Permanentmagneten (P) bestehen.

2.) "Magnetokalorische monostabile und bistabile Induktoren, nach Anspruch 1, dadurch gekennzeichnet, daß bei der monostabilen Ausführung die Steuerkerne (3) in die Schenkelgabeln der Polschuhe (PO, PO1) möglichst luftspaltlos einmünden, wobei sie zu den ungleichnamigen Magnetpolen magnetisch paralell geschaltet sind und einen kleinen Teil des magnetischen Flußes des Permanentmagneten (N-S) noch vor den metamagnetischen Plättchen-(5) stapeln kurzschließen, solange ihre Steuer- Spulen (7) stromlos bleiben. (Fig. 10 b und 11)

3.) "Magnetokalorische monostabile und bistabile Induktoren, nach Anspruch 1, dadurch gekennzeichnet, daß die bistabilen Systeme aus zwei spiegelbildlich gleichen, getrennten Magnetkreisen bestehen, welche entweder nur durch einen Steuerkern (3) und einen Rückschlußkern (9), oder durch zwei Steuerkerne (3) so miteinander verbunden sind, daß jeder Steuerkern (3) oder Rückschlußkern (9) nur die jeweils magnetisch gleichnamigen Polschuhe (PO,PO1),oder Pole, von einem Magnetkreis zum anderen Magnetkreis miteinander verbindet und dabie die Steuerkerne (3) nur in die Polschuhabschnitte (4) einmünden dürfen, welche den Plättchen (5,5$'$) unmittelbar benachbart sind (Fig.1a-b, 2 a-b und Fig. 5)

4.) "Magnetokalorische monostabile und bistabile Induktoren, nach Ansprüchen 1 bis 3, dadurch gekennzeichnet, daß ihre metamagnetischen dünnen Plättchen (5,5$'$) aus gezüchteten Einkristallen der metamagnetischen Selten-Erdmetalle Dysprosium oder Terbium, der Gold-Mangan-Legierung Mn-Au$_2$ oder beliebigen anderen metamagnetischen Stoffen - mittels Trennschleifen, Sägen oder anderen geeigneten mechanischen Bearbeitungs- Verfahren hergestellt werden.

5.) "Magnetokalorische monostabile und bistabile Induktoren, nach Ansprüchen 1 bis 4, dadurch gekennzeichnet, daß die metamagnetischen Plättchen (5,5$'$) zur Vergrößerung ihrer wärmeaufnehmenden Oberflächen, mit beliebigen bekannten Verfahren, - wie Ätzen, Aufdampfen, galvanisch hergestellte Rippen (R) gleichen Materials, oder aus Kupfer- oder Silber- Auftragung bestehen kann und auch beliebige andere Oberflächen vergrößernde Strukturen, wie noppen- oder stachelförmig aufweisen kann.(Fig.7 a-b - c)

6.) "Magnetokalorische monostabile und bistabile Induktoren, nach Ansprüchen 1 bis 3, dadurch gekennzeichnet, daß nur während der Entmagnetisierungs- Phasen oder Zyklen der Jochblechkerne (6, 6$'$) der elektrische Stromkreis ihrer Induktions- Spulen (8, 8$'$) zu einem Verbraucher geschlossen werden darf und darum Dioden (D) oder Thyristoren aufweisen, welche die Induktionsstrom- Richtung der Aufmagnetisierungs- Phasen oder Zyklen von Jochblechkernen (6, 6$'$) ihrer Spulen (8, 8$'$) sperren.

7.) "Magnetokalorische monostabile und bistabile Induktoren, nach Ansprüchen 1 bis 3, dadurch gekennzeichnet, daß die Dynamoblech- Polschuhe (PO, PO 1) ausgehend von der Polfläche der Permanentmagneten (N-S) sich in Richtung der Einmündung der Steuerkerne (3), zur Erhöhung der Feld- und Fluß- Dichte gegenüber den metamagnetischen Plättchen (5, 5$'$), verjüngen können. (Fig. 2 a-b)

8.) "Magnetokalorische monostabile und bistabile Induktoren, nach Ansprüchen 1 bis 3, dadurch gekennzeichnet, daß die Magnetkreise zur Befestigung ihrer Einzelteile, in Abständen Verbindungsteile (Fig.6) aus nicht magnetisierbarem Material, mit Bohrungen (B) aufweisen.

9.) "Magnetokalorische monostabile und bistabile Induktoren, nach einem der Ansprüche 1 bis 8, dadurch gekennzeichnet, daß die Jochkern-(6,6$'$) Dynamobleche und oder die Polschuhbleche (PO, PO 1) Ausnehmungen (Au, Au$'$) und Bohrungen (B) aufweisen können. (Fig. 8 und 5)

10.) "Magnetokalorische monostabile und bistabile Induktoren, nach Ansprüchen 1 bis 9, dadurch gekennzeichnet, daß eine Anlage mit beliebig vielen Induktoren, doppelte Gehäuse-Trennwände (TR) mit Vakuum dazwischen, sowie eine Medienkreislaufpumpe (KP) aufweist, welche das bevorzugt flüssige Kältemittel in einem Kreislauf durch die Schlitze oder Känale aneinandergereihter Plättchen-(5,5$'$) Stapel und einem Wärmetauscher (WT) pumpt.(Fig.9)

**FIG.1 a-b**

**FIG.2 a-b**

Fig.3

MANGAN-GOLD (MN-AU$_2$)

Fig.4

DYSPROSIUM

**FIG.5**

**FIG.6**

SCHNITT A-B

**FIG.7a-c**

**FIG.8**

FIG.9

EP 0 308 611 A1

**FIG.10 a-b**

**FIG.11**

| | EINSCHLÄGIGE DOKUMENTE | | EP 88111642.0 |
|---|---|---|---|
| **Kategorie** | **Kennzeichnung des Dokuments mit Angabe, soweit erforderlich, der maßgeblichen Teile** | **Betrifft Anspruch** | **KLASSIFIKATION DER ANMELDUNG (Int. Cl.4)** |
| X | DE - A1 - 3 106 520 (BRUNGSBERG) <br><br> * Zusammenfassung; Anspruch 1; Seite 4, Zeilen 1-16; Fig. 1,4,5 * <br><br> -- | 1 | H 02 N 11/00 |
| A | FR - A1 - 2 532 489 (GALIMBERTI) <br><br> * Zusammenfassung; Fig. 1 * <br><br> -- | 1 | |
| A | GB - A - 1 235 328 (EUROPEAN ATOMIC ENERGY COMMUNITY) <br><br> * Seite 1, Zeilen 8-21; Fig. 1 * <br><br> -- | 1 | |
| A | US - A - 3 841 107 (ARTHUR C. CLARK) <br><br> * Zusammenfassung; Spalte 2, Zeile 45 - Spalte 3, Zeile 55; Fig. 5 * <br><br> -- | 1 | **RECHERCHIERTE SACHGEBIETE (Int. Cl.4)** <br><br> H 02 N <br> H 01 F |
| D,A | ZEITSCHRIFT FÜR ANGEWANDTE PHYSIK, Band 14, April 1962, Berlin/ Göttingen/Heidelberg, DE <br><br> E. VOGT "Metamagnetismus" Seiten 177-182 <br><br> * Seite 177, Spalte 1, Zeile 1 - Spalte 2, Zeile 10 * <br><br> -- | 1,4 | H 02 K <br> F 25 B |

Der vorliegende Recherchenbericht wurde für alle Patentansprüche erstellt.

| Recherchenort | Abschlußdatum der Recherche | Prüfer |
|---|---|---|
| WIEN | 25-10-1988 | BRUNNER |

| EINSCHLÄGIGE DOKUMENTE | | | EP 88111642.0 |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
| D,A | SOVIET PHYSICS-SOLID STATE, Band 21, Nr. 9, September 1979, Brief Communications 1616(2808) S.A. NIKITIN et al. "Magnetocaloric effect and magnetic phase transitions in a dysprosium single crystal" Seiten 1616, 1617 * Seite 1616, Spalte 1, Zeilen 1-14 * ---- | 1,4 | |
| | | | RECHERCHIERTE SACHGEBIETE (Int. Cl.4) |

Der vorliegende Recherchenbericht wurde für alle Patentansprüche erstellt.

| Recherchenort | Abschlußdatum der Recherche | Prüfer |
|---|---|---|
| WIEN | 25-10-1988 | BRUNNER |